Europäisches Patentamt

(19) European Patent Office

Office européen des brevets

(11) Publication number: **0 176 907**
**B1**

(12) **EUROPEAN PATENT SPECIFICATION**

(45) Date of publication of patent specification: **12.04.89**

(21) Application number: **85112013.9**

(22) Date of filing: **23.09.85**

(51) Int. Cl.⁴: **H 05 K 5/00,** H 05 K 7/18

(54) **Computer modular frame with rectractable stabilizers.**

(30) Priority: **01.10.84 IT 2293984**

(43) Date of publication of application:
**09.04.86 Bulletin 86/15**

(45) Publication of the grant of the patent:
**12.04.89 Bulletin 89/15**

(84) Designated Contracting States:
**DE FR GB**

(56) References cited:
**DE-B-1 160 919**
**US-A-3 586 273**
**US-A-3 988 802**

(73) Proprietor: **HONEYWELL BULL ITALIA S.p.A.**
**Via Martiri d'Italia 10**
**I-10014 Caluso (TO) (IT)**

(72) Inventor: **Lodi, Renato**
**Via Novara 1**
**I-20017 RHO (Milano) (IT)**

Courier Press, Leamington Spa, England.

## Description

The present invention relates to a computer modular frame with retractable stabilizers.

It is known that large data processing systems are constituted by a plurality of cubicles or modular boxes generally arranged the one next to the other and containing electronic circuits.

The stability and the relative positioning of these cubicles is assured by the large size of their basis and by their weight more than by the mechanical connections of cubicles one another.

However the electronic technology development, enabled to reduce the space required for the component housing and the encumbrance of the relative cubicles had been consequently reduced.

In fact these cubicles are planned and intended to be placed side by side to working desks or even under desks.

The height and depth limits established by this installation concept reduce the module width to few tens of centimeters, from 15 to 25 cm while the height and the depth are maintained from 60 to 80 cm to obtain an optimal space exploitation.

A great development in the height direction as to the basis size is therefore adopted which affects the installation stability.

In fact also the weight of such modules is reduced to few tens of Kg and accidental pushes and pressures, due to people movements, can cause the module upsetting.

It is desirable for such modules to have a ground laying structure wide enough to avoid such risk and to allow a safe installation of this modules in an open space.

It is however desirable that such laying structure do not affect the juxtaposition possibility of the modules each other or the approaching of the modules to walls, tables or other office pieces of furniture, as well as the easier handling and packaging offered by a small sized module.

The advantages are achieved by the computer modular frame with retractable stabilizers object of the present invention.

According to the invention as claimed, the laying surface of the modules is extended, in the direction of the minimum size (width) by means of feet or stabilizers skid-mounted on the frame bottom, and extensible in the width direction alternatively from one or from the other side of the frame.

Said feet can present a laterally shifted position so increasing the laying surface, or a retracted surface where the feet are not in sight and do not extend outside the cubicles bases encumbrance, allowing the juxtaposition of frames or their approaching to walls or pieces of furniture, as well as an easier handling and packaging in small containers.

The several feet are movable the one independently from the other in order to enable a selective increase of the laying surface and, in the case of module juxtaposition, to allow an interconnection between the feet of different modules, which assures a correct and safe juxtaposition of the same.

To this purpose the feet of different modules can cooperate with a cover common to several modules.

These advantages and the invention features will appear more clearly from the following description and the enclosed drawings where:

Figure 1 shows in perspective view a computer modular frame with retractable stabilizers object of the present invention;

Figure 2 shows in perspective view a system constituted by two juxtaposed modular frames;

Figure 3 shows in bottom view, a modular frame with retractable feet object of the invention;

Figure 4 shows in section view the retractable feet of the modular frame object of the present invention;

Figures 5, 6, 7 schematically show in top view the possible arrangements of the laying feet of one or more frames in connection with different installation needs;

Figure 8 shows in perspective view the system of Fig. 2 with removed cover.

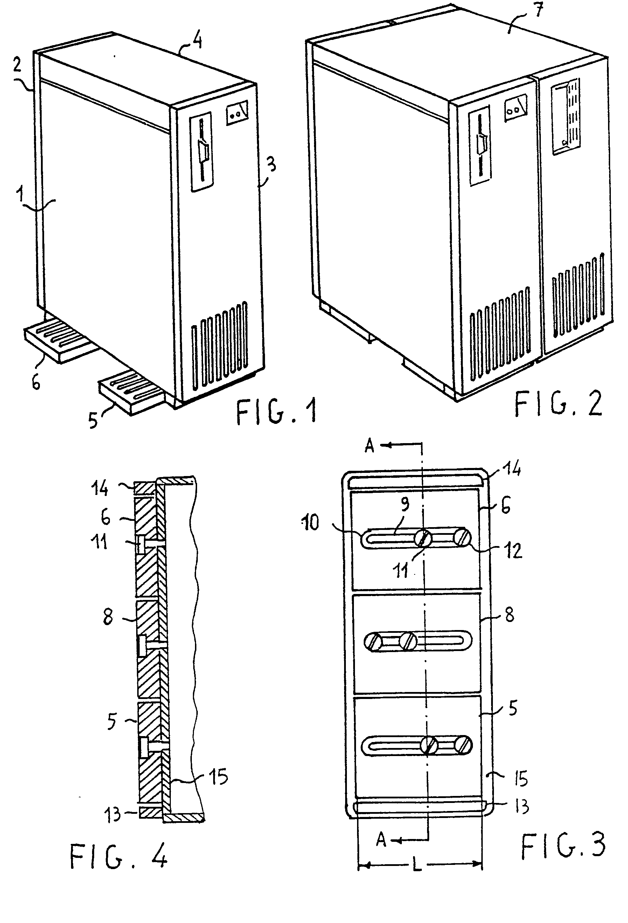

Figure 1 shows in perspective view a computer modular frame with retractable feet.

The frame is constituted by a plate element suitably strengthened by internal stiffening ribs not in sight and U-bent in order to constitute a bottom and two lateral sides for a cubicle housing electronic circuits.

In Fig. 1 a lateral side 1 is shown.

The frame also comprises a back panel 2, a front panel 3 and a cover 4.

The typical sizes for this kind of frame can be: height 67 cm, depth 57 cm, width 18 cm.

The cubicle is provided with a plurality of feet to assure stability. It is preferably provided with three feet, but even an higher number of them is suitable.

The feet are skid-mounted the one behind the other in the length direction on the frame bottom and able to be transversally moved in the width direction.

Two of these feet, 5 and 6 respectively, are shown in Fig. 1 laterally shifted as to side 1.

A third foot, not in sight, and positioned between feet 5 and 6 extends beyond the side opposite to 1.

In this way the cubicle laying width is practically doubled and its stability is assured.

Fig. 2 shows in perspective view a system constituted by two juxtaposed modular frames.

The frames can be kept together by a unitary cover 7. In this case the increase of the laying surface being not necessary, the feet can be retracted under the cubicle bottom in order to be aligned with the cubicle sides.

Fig. 3 shows in bottom view, the retractable feet object of the invention and Fig. 4 shows their section view according to plane A—A.

Three retractable feet 5, 6, 7, rectangular shaped and juxtaposed one to the other in the direction of the cubicle length, lay on frame bottom 15.

The feet length L is, preferably, a pair of centimeters lesser than the cubicle width.

The feet are provided with a groove 9 of suitable width, for instance 10 mm and extending in the direction of the feet length and slightly shorter than the feet length.

On the side intended to lay to the floor the grooves are surrounded by a seat 10 of suitable width, for instance 20 mm and suitable depth for instance 5 mm.

The feet thickness is preferably of about 15 mm.

Each foot is fixed to the frame bottom by means of cylindrical headed screws such as screws 11, 12 for foot 6, which, getting through groove 9, screw into bottom 15 and house their head into slot 10.

The pair of screws are arranged for each foot alternatively at a side or at the other one as to the frame median section.

In this way the feet shown in retracted position, that is within the frame plan, can be moved in drawn out position, alternatively at one side and the other one.

So, with reference to Fig. 3, feet 5 and 6 can move to the figure right and foot 8 to the left.

The feet movement is completely independent the one from the other and therefore enable to obtain the most advantageous configuration to assure the stability of the frame or of a system constituted by several juxtaposed frames in the most different cases.

The laying structure is completed, for aesthetic sake, by a front socket 13 and a back socket 14 strictly restrained to the frame bottom and having a thickness equal to the one of the feet.

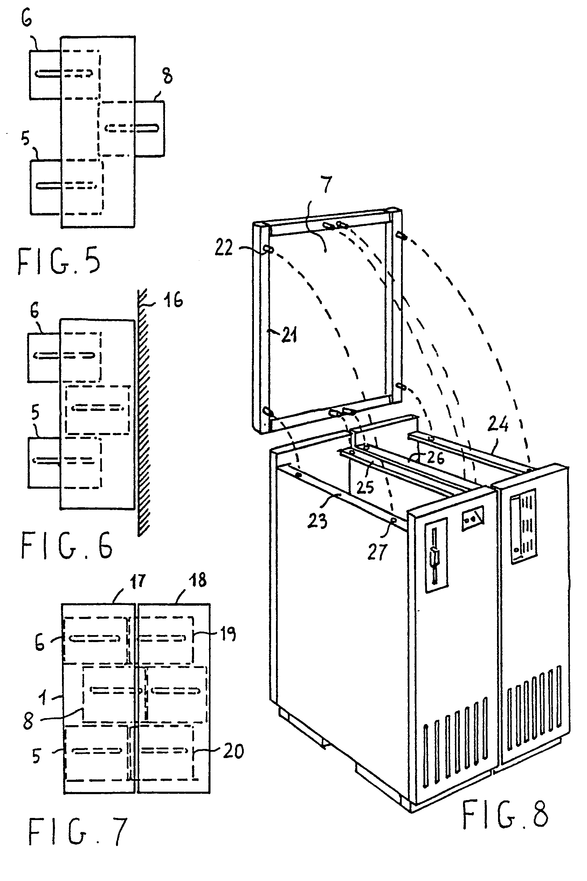

Fig. 5, 6, 7 schematically show, in top view, the possible arrangements of the laying feet as to the frame plan and to the different installation needs.

In Fig. 5 all the feet are laterally shifted for an installation of the frame in an open space.

In Fig. 6 only feet 5, 6 are laterally shifted from the same side for the installation of the frame next to a vertical wall 16.

In Fig. 7 two frames 17, 18 are juxtaposed to constitute a system. The exact frame juxtaposition is assured by the feet arrangement which are interleaved one another.

Feet 5 and 6 of frame 17 are arranged aligned with side 1, in order that feet 19 and 20 of frame 18 can be slightly laterally-shifted and inserted under frame 17.

Foot 8 of frame 17 is slightly laterally shifted in order to be inserted under frame 18 and partially fit in between feet 19 and 20. To obtain this interleaving without requiring the feet to extend outward the projection in plan of the frames, it requires that the feet length is slightly shorter than the frame width, for instance of about 2 cm, as already mentioned.

Such kind of system can be installed in an open space as well as next to a wall.

It is clear that in the case of installation in an open space the laying surface can be increased with the feet completely moved outward. The laying feet of the disclosed type can be advantageously used to constitute a unitary system through the composition of several modules and a common cover.

Fig. 2 shows a system of two modules provided with an unitary cover.

Fig. 8 shows in perspective view the same systems having unitary cover 7 removed to put in sight the connection.

Cover 7 has a bent rim 21 where stop register pins are restrained only one of which is numbered with reference number 22.

The frame sides are bent in correspondence of their upper edge in order to form some stiffening and laying wings 23, 24, 25, 26 for the cover. These wings are pierced to allow the insertion of the cover register pins.

Only one of these openings is numbered with reference number 27.

Pins and openings preferably constitute pairs of pressure fixing elements or "fasteners".

The interconnection of the feet to the frame basis prevents the relative shift of the module bases while the unitary cover prevents relative shifts of the modules at the tops and vibration of the same. The common cover, if embodied as well as the fasteners in conductive material, can further constitute an electrical continuity element and a ground element for the modules, without requiring any ground cabling among the modules.

It is clear that the above description refers to a preferred embodiment of the invention and that several modification can be brought without departing from the scope of the invention.

For instance the retractable feet can be fixed to the frame by means of slide guides where the feet sides are inserted, or the relation slot-fixing screws can be reversed by performing a sliding slot on the frame bottom and screwing the fixing screws of the retractable feet to the feet themselves.

It is to be evidenced that a cover of the previously disclosed type, common to several modules can allow the electrical connection between contiguous and juxtaposed modules by the housing of electrical cables in a free space between cover and juxtaposed sides of the modules. In this way the inconvenients of unaesthetic connection in sight between contiguous modules, typical of the prior art, is avoided.

## Claims

1. Computer modular frame capable of juxtaposition against wall and/or against other similar frames, comprising: N retractable feet where N ≥ 3 each of said feet being shaped as a substantially rectangular sole, being skid-mounted on the bottom of said frame and being shiftable in the direction of lower encumbrance of said frame, two sides of said rectangular sole being parallel to the shifting direction.

2. Modular frame as per claim 1 characterized by that said N feet are mounted juxtaposed the one to the other one in the direction perpendicular to said shifting direction.

3. Modular frame as per claim 2 characterized by that said N feet have a length, in said shifting direction, 2 cm at least lesser than the frame encumbrance in the same direction.

4. Modular frame system, constituted by at least a pair of modular frames as claimed in claim 2, arranged side by side and juxtaposed in said shifting direction, characterized by that it comprises a common cover locking in juxtaposition said modular frames.

5. Modular frame systems, constituted by at least a pair of modular frames as claimed in claim 3, arranged side by side and juxtaposed in said shifting direction, characterized by that it comprises a common cover locking in juxtaposition said modular frames.

**Patentansprüche**

1. Modulares Rechnergestell, zum Anstellen an eine Wand und/oder an ein anderes entsprechendes Gestell, mit N herausziehbaren Füßen, wobei N≥3 und jeder der Füße als praktisch rechtwinklige Platte gestaltet, in Gleitschienen am Boden des Gestells gehalten und in Richtung der geringeren Flächenausdehnung des Gestellt verschiebbar ist und wobei zwei Seiten der rechtwinkligen Platte sich in Verschieberichtung erstrecken.

2. Modulares Gestell nach Anspruch 1, dadurch gekennzeichnet, daß die N Füße rechtwinklig zur Verschieberichtung einer neben dem anderen angeordnet sind.

3. Modulares Gestell nach Anspruch 2, dadurch gekennzeichnet, daß die N Füße in Verschieberichtung eine Länge haben, die 2 cm kürzer ist als die Ausdehnung des Gestells in dieser Richtung.

4. Modulare Gestellanordnung mit wenigstens zwei modularen Gestellen gemäß Anspruch 2, die in Verschieberichtung dicht nebeneinander angeordnet sind, dadurch gekennzeichnet, daß ein gemeinsamer Deckel die nebeneinander stehenden Gestelle zusammen verriegelt.

5. Modulare Gestellanordnung mit wenigstens zwei modularen Gestellen gemäß Anspruch 3, die in Verschieberichtung dicht nebeneinander angeordnet sind, dadurch gekennzeichnet, daß ein gemeinsamer Deckel die nebeneinander stehenden Gestelle zusammen verriegelt.

**Revendications**

1. Bâti modulaire pour ordinateur, pouvant être juxtaposé contre un mur et/ou contre d'autres bâtis semblables, comprenant: N pieds rétractables, avec N≥3 chacun desdits pieds ayant une semelle de forme sensiblement rectangulaire, étant monté sur patins au fond dudit bâti, et pouvant être déplacé dans le sens de la dimension la plus petite dudit bâti, deux côtés de ladite semelle rectangulaire étant parallèles à la direction de déplacement.

2. Bâti modulaire selon la revendication 1, caractérisé par le fait que lesdits N pieds sont montés les uns à côté des autres, perpendiculairement à ladite direction de déplacement.

3. Bâti modulaire selon la revendication 2, caractérisé par le fait que lesdits N pieds, dans le sens de leur déplacement, sont d'une longueur au moins inférieure de 2 cm, à la longueur du bâti dans ce même sens.

4. Système de bâtis modulaires, constitué par au moins deux bâtis modulaires selon la revendication 2, disposés côte à côte et juxtaposés dans ladite direction de déplacement, caractérisé par le fait qu'il comprend un capot commun bloquant la juxtaposition desdits bâtis modulaires.

5. Système de bâtis modulaires, constitué par au moins deux bâtis modulaires selon la revendication 3, disposés côte à côte et juxtaposés dans ladite direction de déplacement, caractérisé par le fait qu'il comprend un capot commun bloquant la juxtaposition desdits bâtis modulaires.

FIG. 1

FIG. 2

FIG. 4

FIG. 3

FIG.5

FIG.6

FIG.7

FIG.8